# EUROPÄISCHE PATENTSCHRIFT

(11) **EP 1 230 711 B1**
(45) Veröffentlichungstag und Bekanntmachung des Hinweises auf die Patenterteilung: **27.08.2003**
(21) Anmeldenummer: 00987126.0
(22) Anmeldetag: 09.11.2000
(51) Int. Cl.: H01L 21/00, H01L 23/48, H01L 25/065

(54) **ANORDNUNG ZUR ELEKTRISCHEN VERBINDUNG ZWISCHEN CHIPS IN EINER DREIDIMENSIONAL AUSGEFÜHRTEN SCHALTUNG**
ARRANGEMENT FOR ELECTRICALLY CONNECTING CHIPS IN A CIRCUIT THAT IS EMBODIED IN A THREE-DIMENSIONAL MANNER
DISPOSITIF POUR LA CONNEXION ELECTRIQUE DE PUCES DANS UN CIRCUIT A CONFIGURATION TRIDIMENSIONNELLE

(30) Priorität: 15.11.1999 DE 19954895
(43) Veröffentlichungstag der Anmeldung: 14.08.2002
(73) Patentinhaber: Infineon Technologies AG, 81669 München (DE)
(72) Erfinder: ZELSACHER, Rudolf, A-9020 Klagenfurt (AT)
(74) Vertreter: Kottmann, Heinz Dieter, Dipl.-Ing.
(86) Internationale Anmeldenummer: DE0003980
(87) Internationale Veröffentlichungsnummer: WO01037376

(56) Entgegenhaltungen:
- EP-A- 0 722 201
- DE-A- 4 209 072
- US-A- 4 760 335
- US-A- 5 474 458

## Beschreibung

Die vorliegende Erfindung betrifft eine Anordnung zur elektrischen Verbindung zwischen Halbleiterchips, die übereinander in einer dreidimensional ausgeführten Schaltung angeordnet sind, mit Leiterbahnen, die von der einen aktiven Oberseite eines Halbleiterchips durch diesen hindurch zu der anderen, der einen aktiven Oberseite des Halbleiterchips gegenüberliegenden Oberseite geführt sind, und mit Kontaktstöpseln, über die übereinander angeordnete Halbleiterchips elektrisch miteinander verbunden sind.

In elektronischen Geräten, wie beispielsweise Personalcomputern (PC), Laptops, elektronischen Notizbüchern usw. soll die Pakkungsdichte durch dreidimensionale bzw. 3D-Anordnung von in diesen Geräten verwendeten Halbleiterchips möglichst hoch sein. Ein Beispiel für eine derartige 3D-Anordnung ist ein PENTIUM-Halbleiterchip, der direkt auf einem 1-Gigabit-DRAM-Speicher-Halbleiterchip vorgesehen und zusammen mit diesem in einem gemeinsamen Gehäuse untergebracht ist.

Bisher wird die elektrische Verbindung zwischen solchen Halbleiterchips vorzugsweise durch Bonden mittels Drähten oder durch elektrisch leitende Verbindungen auf Platinen hergestellt. Beides erfordert zusätzlichen Raum zur Führung der Bonddrähte bzw. für die Unterbringung der Platinen, so daß einer Steigerung der Pakkungsdichte Grenzen gesetzt sind.

Im einzelnen ist in der US 5,608,264 noch eine oberflächenmontierte integrierte Schaltung beschrieben, bei der zwischen Leiterbahnen und Halbleiterchips Oxidschichten vorgesehen sind.

Weiterhin ist aus der US 5,528,080 eine Schaltungsanordnung bekannt, bei der Leiterbahnen durch Thermomigration von leitendem Material in einem Halbleiterkörper erzeugt sind, um elektrische Verbindungen zwischen einander gegenüberliegenden Oberflächen zu schaffen. Ähnliche, durch Thermomigration erzeugte leitende Verbindungen, welche pn-Übergänge bilden, sind auch in der US 3,904,442 beschrieben.

Schließlich sind durch Thermomigration erzeugte Leiterbahnen zwischen verschiedenen Oberflächen eines Halbleiterkörpers auch aus der US 4,761,681 und der US 4,612,083 bekannt.

Es ist Aufgabe der vorliegenden Erfindung, eine Anordnung zur elektrischen Verbindung zwischen Halbleiterchips in einer dreidimensional ausgeführten Schaltung anzugeben, die es erlaubt, eine besonders hohe Packungsdichte für die Halbleiterchips zu erreichen, und die dabei dennoch eine zuverlässige Isolation von Leiterbahnen von anderen Zonen des Halbleiterchips zu gewährleisten vermag.

Diese Aufgabe wird bei einer Anordnung der eingangs genannten Art erfindungsgemäß dadurch gelöst, daß die Leiterbahnen von durch Thermomigration eines leitenden Materials erzeugte Bereiche umgeben und dadurch durch einen pn-Übergang von anderen Zonen des Halbleiterchips elektrisch isoliert sind.

Zur elektrischen Verbindung von Halbleiterchips in 3D-Anordnung kann an sich anstelle der verbreiteten Bonddrähte oder Platinen die Thermomigration ausgenutzt werden: beispielsweise wird Aluminium auf einen n-leitenden Siliziumwafer durch Verdampfen aufgebracht und strukturiert. Mittels einer schnellen thermischen Behandlung (RTP) wird sodann im Siliziumwafer ein Temperaturgradient erzeugt. Das auf den Siliziumwafer aufgetragene Aluminium beginnt dann entlang des Temperaturgradienten im Siliziumwafer zu wandern und bildet dort einen hochdotierten p-leitenden Bereich. Für einen Durchgang eines solchen Bereiches durch den Siliziumwafer wird - abhängig von der Schichtdicke des Siliziumwafers - eine Zeitdauer von einigen Minuten benötigt.

Durch Ausnutzung dieser Thermomigration von beispielsweise Aluminium in einem n-leitenden Siliziumwafer lassen sich so vertikale leitende Leiterbahnen bzw. Kanäle von der aktiven Oberfläche eines in dem Halbleiterwafer ausgeführten Halbleiterchips bis zu dessen Rückseite erzeugen.

Sollen in einem p-leitenden Siliziumwafer n-leitende Kanäle erzeugt werden, so kann eine Thermomigration von Arsen vorgenommen werden.

Anstelle von den angegebenen leitenden Materialien, nämlich Aluminium und Arsen, können gegebenenfalls auch andere Stoffe eingesetzt werden.

In jedem Fall werden die Leiterbahnen bildenden Kanäle unterhalb von später zu erzeugenden Pads bzw. Kontaktkissen von der einen aktiven Oberfläche des Halbleiterwafers aus erzeugt. Diese Kanäle bzw. Leiterbahnen benötigen daher keine zusätzliche Fläche.

Bei der erfindungsgemäßen Anordnung sind nun Leiterbahnen von durch Thermomigration eines leitenden Materials erzeugten Bereichen umgeben, um durch den dadurch gebildeten pn-Übergang für eine elektrische Isolation von anderen Zonen des Halbleiterchips zu sorgen.

Ein mit einem Halbleiterchip zu verbindender zweiter Halbleiterchip erhält auf seiner aktiven Oberfläche Stöpsel, die beispielsweise aus Aluminium bestehen können und deren Oberfläche in einem Muster vorgesehen ist, das dem Muster der Kanäle auf der gegenüberliegenden Oberseite des zuerst genannten Halbleiterchips entspricht. Auf diesem zweiten Halbleiterchip wird dann der erste Halbleiterchip mit seiner gegenüberliegenden Oberfläche aufgesetzt, so daß die dort endenden Kanäle die Aluminium-Stöpsel berühren.

Die einzelnen Oberflächen der die Halbleiterchips bildenden Halbleiterwafer, können nach der Thermomigration in üblicher Weise durch chemisch-mechanisches Polieren oder chemische Reaktionen nachbehandelt werden, um so die Oberflächen für die nächsten Schritte vorzubereiten.

Nachfolgend wird die Erfindung anhand der Zeichnungen näher erläutert. Es zeigen:
- Fig. 1 und 2: einen Grundriß bzw. einen Aufriß eines Halbleiterchips
- Fig. 3 und 4: einen Grundriß bzw. einen Aufriß der erfindungsgemäßen Anordnung, und
- Fig. 5: eine schematische Darstellung eines weiteren Ausführungsbeispiels der Erfindung.

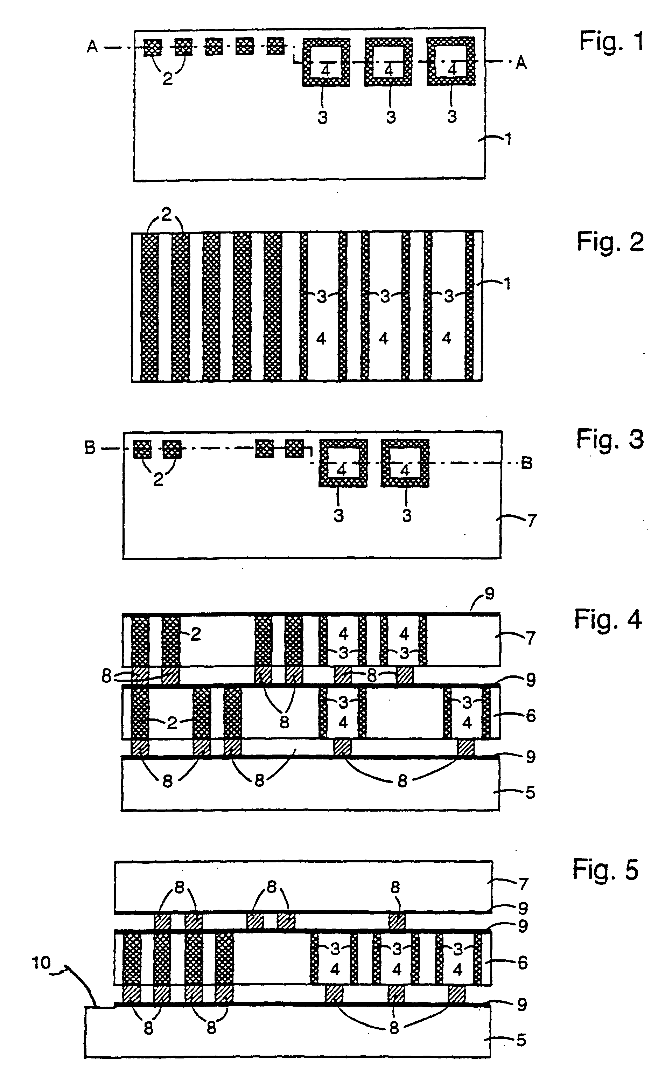

Die Fig. 1 und 2 zeigen einen n-dotierten Siliziumchip 1, auf dessen Oberfläche Aluminium aufgebracht und in ein bestimmtes Muster strukturiert wurde. An dieses Strukturieren schließt sich ein RTP-Prozeß an, bei dem im Siliziumchip 1 ein Temperaturgradient erzeugt wird. Das Aluminium breitet sich dann längs dieses Temperaturgradienten in die Tiefe des Siliziumchips 1 aus und bildet so säulenförmige p-leitende Kanäle oder Leiterbahnen 2.

Erfindungsgemäß ist es nun möglich, Aluminium "rahmenförmig" zu gestalten, so daß es ein n-leitendes Gebiet umgibt. In diesem Fall bildet dann das durch den p-leitenden Bereich 3 umgebene n-leitende Gebiet 4 einen säulenförmigen n-leitenden Kanal, der zwischen den beiden Oberseiten des Siliziumchips 1 geführt ist. Dieses n-leitende Gebiet 4 ist dabei elektrisch durch den p-leitenden Bereich 3 von anderen Zonen des Siliziumchips 1 isoliert.

Ist der Siliziumchip 1 p-leitend, so können in diesem n-leitende Strukturen, die den Strukturen der Fig. 1 und 2 entsprechen, durch Auftragen und Thermomigration von Arsen erzeugt werden. Die oben angegebenen Leitungstypen können also jeweils umgekehrt werden, was auch für die folgenden Ausführungsbeispiele gilt.

Aus der Fig. 2, die einen Aufriß in einem Schnitt AA durch den Grundriß von Fig. 1 zeigt, ist zu ersehen, daß die durch Thermomigration erzeugten Kanäle 2 bzw. Bereiche 4 gerade von der einen Oberseite des Siliziumchips 1 zu dessen anderer Oberseite verlaufen und auf diesem keine zusätzliche Fläche beanspruchen, da sie unterhalb entsprechender Pads angeordnet sind. Es sei angemerkt, daß in den Fig. 1 bis 4 der besseren Übersichtlichkeit wegen die Kanäle 2 und die rahmenförmigen Bereiche 3 im Vergleich zum Chip 1 stark vergrößert dargestellt sind.

Bei dem Ausführungsbeispiel der Fig. 3 und 4 sind ein 128-Megabit-EEPROM-Halbleiterchip 5, ein PENTIUM-Halbleiterchip 6 und ein 1-Gigabit-DRAM-Halbleiterchip 7 übereinander vorgesehen. Der PENTIUM-Halbleiterchip 6 weist dabei auf seiner Oberseite Kontaktstöpsel 8 auf, deren Muster dem Muster der Kanäle 2 bzw. leitenden Gebiete 4 auf der Rückseite des Halbleiterchips 7 entspricht. In ähnlicher Weise sind auf der aktiven Oberseite des EEPROM-Halbleiterchips 5 solche Kontaktstöpsel 8 zur elektrischen Verbindung mit der Rückseite des PENTIUM-Halbleiterchips 6 vorgesehen. Diese aktiven Oberseiten der Halbleiterchips 5, 6, 7 sind durch Balkenlinien 9 angedeutet.

Aus der Fig. 4, die einen Aufriß in einem Schnitt BB durch Fig. 3 zeigt, ist zu ersehen, wie durch die durch Thermomigration erzeugten Kanäle bzw. Leiterbahnen 2 bzw. wie durch die Gebiete 4, die von den durch Thermomigration erzeugten Bereichen 3 umgeben sind, elektrische Verbindungen zwischen den Halbleiterchips 5, 6 und 7 aufgebaut werden, wobei zwischen diesen Halbleiterchips 5, 6 und 7 an den entsprechenden Stellen Kontaktstöpsel 8 aus beispielsweise Aluminium vorgesehen sind. Diese Kontaktstöpsel 8 befinden sich vorzugsweise auf der aktiven Oberfläche 9 der Halbleiterchips 5 und 6 und sorgen so für eine elektrische Verbindung zu der aktiven Oberfläche des jeweils darüber liegenden Halbleiterchips.

Die Thermomigration wird zur Herstellung von leitenden Kanälen bzw. Leiterbahnen durch Halbleiterchips hindurch ausgenutzt, um so mit Hilfe dieser leitenden Kanäle bzw. Leiterbahnen elektrische Verbindungen zwischen einzelnen Halbleiterchips in einer dreidimensionalen Schaltungsanordnung aufzubauen.

Werden zur elektrischen Verbindung erfindungsgemäß die Gebiete 4 eingesetzt, die in den rahmenförmigen Bereichen 3 angeordnet sind, so müssen diese Gebiete 4 selbstverständlich ausreichend hoch dotiert sein, um eine niederohmige Verbindung zwischen den einzelnen Halbleiterchips herstellen zu können.

Für die Kontaktstöpsel 8 kann außer Aluminium auch jedes andere geeignete Material gewählt werden, wie beispielsweise Gold usw..

In Fig. 5 ist ein Ausführungsbeispiel gezeigt, bei dem ein 128-Megabit-EEPROM-Halbleiterchip 5, ein Pentium-Halbleiterchip 6 und ein 1 Gigabit-DRAM-Halbleiterchip 7 übereinander liegen, wobei hier die Kanäle 2 bzw. leitenden Gebiete 4 nur im mittleren Chip 6 verlaufen und an dessen Ober- und Unterseite über die Kontaktstöpsel 8 mit den Oberseiten der anderen Chips 5 bzw. 7 kontaktiert sind. Der Chip 5 kann dabei mit Bonddrähten 10 versehen sein.

Aus der Fig. 5 ist zu ersehen, wie die Kanäle 2 bzw. Bereiche 4 und die Kontaktstöpsel 8 Verbindungen zwischen den einzelnen Chips erlauben, nämlich beispielsweise (von links nach rechts in dieser Figur) von Chip 5 zur aktiven Oberfläche 9 des Chips 6, von Chip 5 zu Chip 7, von Chip 5 zu Chip 7, von Chip 5 zur aktiven Oberfläche 9 des Chips 6, von Chip 6 zu Chip 7 und nochmals von Chip 6 zu Chip 7 sowie erfindungsgemäß von Chip 5 zur aktiven Oberfläche 9 von Chip 6, von Chip 5 zu Chip 7 und von Chip 5 zur aktiven Oberfläche 9 von Chip 6.

Bei den obigen Ausführungsbeispielen besteht der Halbleiterchip 1 bzw. 5, 6, 7 jeweils aus Silizium. Die Erfindung ist aber nicht hierauf beschränkt, sondern kann auch bei Halbleiterchips angewandt werden, die aus einem anderen Material als Silizium, beispielsweise aus AIII-BV-Verbindungen hergestellt sind, indem in diese ein geeignetes leitendes Material eingebracht wird, das durch Thermomigration die gewünschten leitenden Kanäle bzw. Leiterbahnen aufbaut.

## Patentansprüche

1. Anordnung zur elektrischen Verbindung zwischen Halbleiterchips (5, 6, 7), die übereinander in einer dreidimensional ausgeführten Schaltung angeordnet sind, mit Leiterbahnen (4), die von der einen aktiven Oberseite (9) eines Halbleiterchips (5, 6, 7) durch diesen hindurch zu der anderen, der einen aktiven Oberseite des Halbleiterchips (5, 6, 7) gegenüberliegenden Oberseite geführt sind, und mit Kontaktstöpseln (8), über die übereinander angeordnete Halbleiterchips (5, 6, 7) elektrisch miteinander verbunden sind,
**dadurch gekennzeichnet, dass**
die Leiterbahnen (4) von durch Thermomigration eines leitenden Materials erzeugte Bereichen (3) umgeben und dadurch durch einen pn-Übergang von anderen Zonen des Halbleiterchips (5, 6, 7) elektrisch isoliert sind.

2. Anordnung nach Anspruch 1,
**dadurch gekennzeichnet, daß** das leitende Material in einem n-leitenden Halbleiterkörper des Halbleiterchips (5, 6, 7) Aluminium ist.

3. Anordnung nach Anspruch 1,
**dadurch gekennzeichnet, daß** das leitende Material in einem p-leitenden Halbleiterkörper des Halbleiterchips (5, 6, 7) Arsen ist.

4. Anordnung nach einem der Ansprüche 1 bis 3,
**dadurch gekennzeichnet, daß** die Kontaktstöpsel (8) auf der aktiven Oberseite (9) des Halbleiterchips (5, 6, 7) angebracht sind.

5. Anordnung nach einem der Ansprüche 1 bis 4,
**dadurch gekennzeichnet, daß** die Kontaktstöpsel (8) aus Aluminium gebildet sind.

6. Anordnung nach einem der Ansprüche 1 bis 5,
**dadurch gekennzeichnet, daß** der Halbleiterchip (5, 6, 7) aus Silizium besteht.

## Claims

1. Arrangement for electrical connection between semiconductor chips (5, 6, 7) arranged one above the other in a three-dimensionally embodied circuit, having interconnects (4), which are led from one active top side (9) of a semiconductor chip (5, 6, 7) through the latter to the other top side, opposite the first active top side of the semiconductor chip (5, 6, 7), and having contact plugs (8), via which semiconductor chips (5, 6, 7) arranged one above the other are electrically connected to one another,
**characterized in that**
the interconnects (4) are surrounded by regions (3) produced by thermomigration of a conductive material and are thereby electrically insulated from other zones of the semiconductor chip (5, 6, 7) by a pn junction.

2. The arrangement as claimed in Claim 1,
**characterized in that**
the conductive material in an n-conducting semiconductor body of the semiconductor chip (5, 6, 7) is aluminium.

3. The arrangement as claimed in Claim 1,
**characterized in that**
the conductive material in a p-conducting semiconductor body of the semiconductor chip (5, 6, 7) is arsenic.

4. The arrangement as claimed in one of Claims 1 to 3,
**characterized in that**
the contact plugs (8) are provided on the active top side (9) of the semiconductor chip (5, 6, 7).

5. The arrangement as claimed in one of Claims 1 to 4,
**characterized in that**
the contact plugs (8) are formed from aluminium.

6. The arrangement as claimed in one of Claims 1 to 5,
**characterized in that**
the semiconductor chip (5, 6, 7) is composed of silicon.

## Revendications

1. Dispositif de connexion électrique entre des puces (5, 6, 7) à semi-conducteur qui sont superposées dans un circuit à trois dimensions, comprenant des pistes (4) conductrices qui vont d'une face (9) active d'une puce (5, 6, 7) à semi-conducteur en passant à travers celle-ci à l'autre face supérieure opposée à la face active de la puce (5, 6, 7) à semi-conducteur et des fiches (8) de contact par lesquelles les puces (5, 6, 7) à semi-conducteur superposées sont connectées électriquement entre elles,
**caractérisé en ce que** les pistes (4) conductrices sont entourées de parties (3) produites par thermomigration d'un matériau conducteur et sont ainsi isolées électriquement d'autres zones de la puce (5, 6, 7) à semi-conducteur par une jonction pn.

2. Dispositif suivant la revendication 1,
**caractérisé**
**en ce que** le matériau conducteur dans un corps semi-conducteur de conductivité n de la puce (5, 6, 7) à semi-conducteur est de l'aluminium.

3. Dispositif suivant la revendication 1,
**caractérisé**
**en ce que** le matériau conducteur dans un corps semi-conducteur de conductivité p de la puce (5, 6, 7) à semi-conducteur est de l'arsenic.

4. Dispositif suivant l'une des revendications 1 à 3,
**caractérisé**
**en ce que** les fiches (8) de contact sont disposées sur la face (9) active de la puce (5, 6, 7) à semi-conducteur.

5. Dispositif suivant l'une des revendications 1 à 4,
**caractérisé**
**en ce que** les fiches (8) de contact sont en aluminium.

6. Dispositif suivant l'une des revendications 1 à 3,
**caractérisé**
**en ce que** la puce (5, 6, 7) à semi-conducteur est en silicium.
